# EUROPÄISCHE PATENTSCHRIFT

(11) **EP 1 368 833 B1**
(45) Veröffentlichungstag und Bekanntmachung des Hinweises auf die Patenterteilung: **25.05.2005**
(21) Anmeldenummer: 02719674.0
(22) Anmeldetag: 07.03.2002
(51) Int. Cl.: H01L 23/525

(54) **INTEGRIERTE SCHALTUNG MIT ELEKTRISCHEN VERBINDUNGSELEMENTEN**
INTEGRATED CIRCUIT COMPRISING ELECTRIC CONNECTING ELEMENTS
CIRCUIT INTEGRE DOTE D'ELEMENTS DE CONNEXION ELECTRIQUE

(30) Priorität: 15.03.2001 DE 10112543
(43) Veröffentlichungstag der Anmeldung: 10.12.2003
(73) Patentinhaber: Infineon Technologies AG, 81669 München (DE)
(72) Erfinder: LEHR, Matthias, Uwe, 01309 Dresden (DE); MÖCKEL, Jens, 81739 München (DE); TÖBBEN, Dirk, 81827 München (DE)
(74) Vertreter: Epping Hermann & Fischer
(86) Internationale Anmeldenummer: PCT/DE2002/000822
(87) Internationale Veröffentlichungsnummer: WO 2002/075810

(56) Entgegenhaltungen:
- EP-A- 1 045 441
- US-A- 5 636 172
- US-A- 5 986 321
- US-B1- 6 172 896

## Beschreibung

Die vorliegende Anmeldung betrifft eine integrierte Schaltung mit elektrischen Verbindungselementen, die jeweils einen ersten Leitfähigkeitszustand oder einen durch Energieeinprägung herbeiführbaren anderen zweiten Leitfähigkeitszustand aufweisen.

Elektrische Verbindungselemente, die einen ersten Zustand oder einen zweiten Zustand aufweisen, werden auch als Sicherungen oder Fuses bezeichnet. Hierbei werden beispielsweise Laser-Fuses und elektrische Fuses unterschieden. Laser-Fuses werden mittels des von einem Laser emittierten Lichtes programmiert. Elektrische Fuses werden im Gegensatz dazu mittels eines elektrischen Stromes, der durch die Fuses hindurchfließt, programmiert. Bei elektrischen Fuses werden Fuses und Antifuses unterschieden, je nachdem, ob das elektrische Verbindungselement im nicht programmierten Zustand leitend oder nicht leitend ist. Fuses sind meist nur einmal programmierbar.

Fuses werden beispielsweise in integrierten Schaltungen verwendet, um nach einer Funktionsüberprüfung einen defekten Funktionsblock des integrierten Schaltkreises durch einen redundanten Funktionsblock zu ersetzen. Laser-Fuses sind üblicherweise so ausgebildet, daß sie zunächst eine leitende Verbindung bilden. Eine Laser-Fuse wird mittels eines Lasers programmiert, indem ein Laserstrahl die leitende Verbindung zerstört. Generell betrachtet können Sicherungen aus einem beliebigen leitenden Material gebildet sein. Beispielsweise können die Sicherungen aus einem Metall hergestellt sein. Die Sicherungen sind üblicherweise in einem abgegrenzten Gebiet der Substratoberfläche angeordnet. Dieses Gebiet wird beispielsweise als Laser-Fuse-Bay oder Fuse-Bank bezeichnet. Üblicherweise haben die in der Fuse-Bank angeordneten Sicherungen einen vorbestimmten Abstand voneinander. Falls die Sicherungen mit einem zu geringen Abstand zu benachbarten Sicherungen angeordnet sind, so kann beim Programmieren einer Sicherung eine benachbarte Sicherung durch die Absorption von reflektiertem oder direktem Laserlicht beschädigt werden. Ebenso ist es möglich, daß eine bereits programmierte und damit durchtrennte Sicherung durch Material kurzgeschlossen wird, welches beim Programmieren einer zu ihr benachbarten Sicherung freigesetzt wird.

Die Notwendigkeit, einen relativ großen Abstand zwischen benachbarten Sicherungen einzuhalten, führt zukünftig zu Problemen, da die für eine integrierte Schaltung nutzbare Fläche stetig verkleinert wird, so daß ebenfalls das Laser-Fuse-Bay verkleinert werden muß.

Aus dem Stand der Technik ist bekannt, daß der Abstand zwischen zwei benachbarten Sicherungen verringert werden kann, wenn sogenannte Staggered-Fuses gebildet werden. Hierbei wird das mittels des Lasers durchtrennbare Material in einer ersten Metallage gefertigt und die Zuleitung zu dem mittels des Lasers programmierbaren Material in einer zweiten darüber angeordnete Metallisierungsebene gefertigt, die beispielsweise näher an der Substratoberfläche angeordnet ist als die erste Metallage. Die Zuleitung wird beispielsweise mittels eines Kontaktloches von der ersten Verdrahtungsebene (1. Metallage) zu der zweiten Verdrahtungsebene (2. Metallage) geführt. Bei Staggered-Fuses ist problematisch, daß der Laserstrahl beim Programmieren einer Sicherung die in den tiefer angeordneten Verdrahtungsebenen angeordneten Zuleitungen für benachbarte Sicherungen beschädigen kann.

Es ist die Aufgabe der Erfindung, eine Anordnung von Sicherungen anzugeben, die platzsparend ist und bei einem Programmieren mittels eines Lasers eine Beschädigung von benachbarten Leiterbahnen oder Sicherungen vermeidet.

Erfindungsgemäß wird die Aufgabe gelöst durch eine integrierte Schaltung mit elektrischen Verbindungselementen, die jeweils einen ersten Leitfähigkeitszustand oder einen durch Energieeinprägung herbeiführbaren anderen zweiten Leitfähigkeitszustand aufweisen, umfassend:
- ein Substrat mit einer Substratoberfläche, die eine erste Ausdehnungsrichtung und eine senkrecht dazu verlaufende zweite Ausdehnungsrichtung aufweist;
- ein erstes elektrisches Verbindungselement und ein zweites elektrisches Verbindungselement, die gesehen in der zweiten Richtung nebeneinander oberhalb der Substratoberfläche in einer ersten Verdrahtungsebene angeordnet sind;
- ein drittes elektrisches Verbindungselement und ein viertes elektrisches Verbindungselement, die im wesentlichen gesehen in der zweiten Richtung nebeneinander auf der Substratoberfläche angeordnet sind;
- wobei ein Ende des dritten elektrischen Verbindungselements und ein Ende des vierten elektrischen Verbindungselements entlang der ersten Richtung von einem Ende des ersten elektrischen Verbindungselements und einem Ende des zweiten elektrischen Verbindungselements beabstandet sind und
- wobei das erste elektrische Verbindungselement gesehen in der zweiten Richtung einen ersten Abstand von dem zweiten elektrischen Verbindungselement aufweist;
- eine erste Leiterbahn, die oberhalb der Substratoberfläche angeordnet ist und mit dem ersten elektrischen Verbindungselement verbunden ist;
- eine zweite Leiterbahn, die oberhalb der Substratoberfläche angeordnet ist und mit dem zweiten elektrischen Verbindungselement verbunden ist;
- wobei die erste Leiterbahn und die zweite Leiterbahn zwischen dem dritten elektrischen Verbindungselement und dem vierten elektrischen Verbindungselement angeordnet sind und dort einen zweiten Abstand aufweisen, der kleiner ist als der erste Abstand;
- und die erste Leiterbahn in der ersten Verdrahtungsebene angeordnet ist und die zweite Leiterbahn zumindest teilweise in einer zweiten Verdrahtungsebene angeordnet ist, die näher zur Substratoberfläche liegt als die erste Verdrahtungsebene.

Ein Vorteil der erfindungsgemäßen Anordnung liegt darin, daß die elektrischen Verbindungselemente auf der Substratoberfläche mit einem ersten Abstand beabstandet sind, der vorteilhafterweise so gewählt ist, daß eine Beschädigung von Sicherungen bei dem Programmieren einer benachbarten Sicherung vermieden wird. Weiterhin sind Leiterbahnen auf der Substratoberfläche so angeordnet, daß sie einen.geringeren Abstand aufweisen als die mit ihnen verbundenen elektrischen Verbindungselemente. Dies weist den Vorteil auf, daß Leiterbahnen auf der Substratoberfläche sehr kompakt angeordnet werden können. Zusätzlich werden die Leiterbahnen so auf der Substratoberfläche angeordnet, daß sie zwischen zwei benachbarten elektrischen Verbindungselementen verlaufen.

Der Abstand der elektrischen Verbindungselemente zueinander ist vorteilhafterweise ebenfalls so gewählt, daß eine benachbarte, bereits programmierte Sicherung nicht durch Material, welches beim Programmieren der Sicherung abgetragen wird, kurzgeschlossen wird. Durch die erfindungsgemäße Anordnung kann die für eine Fuse-Bank benötigte Substratoberfläche, bei konstant gehaltener Anzahl von elektrischen Verbindungselementen in der Fuse-Bank, verringert werden.

Eine vorteilhafte Ausgestaltung der integrierten Schaltung sieht vor, daß die erste Leiterbahn und die zweite Leiterbahn in Richtung einer Substratnormalen, die senkrecht auf der Substratoberfläche angeordnet ist, nebeneinander angeordnet sind. Dadurch werden zwischen zwei elektrischen Verbindungselementen zwei oder mehr Leiterbahnen übereinander auf der Substratoberfläche angeordnet. Dies hat den Vorteil, daß die Leiterbahnen, die mit elektrischen Verbindungselementen verbunden sind, sehr kompakt und eng benachbart zueinander gebildet werden können.

In der integrierten Schaltung sind auf der Substratoberfläche eine erste Verdrahtungsebene und eine zweite Verdrahtungsebene angeordnet, wobei die erste Verdrahtungsebene einen anderen Abstand zu der Substratoberfläche aufweist als die zweite Verdrahtungsebene. Die erste Verdrahtungsebene weist zur Substratoberfläche hin einen größeren Abstand auf als die zweite Verdrahtungsebene. Die zweite Verdrahtungsebene liegt näher zur Substratoberfläche als die erste Verdrahtungsebene. Zweckmäßigerweise ist die erste Verdrahtungsebene die oberste Verdrahtungsebene der integrierten Schaltung. Hierdurch wird eine platzsparende Anordnung von Leiterbahnen ermöglicht, da Leiterbahnen in Richtung der Substratnormalen voneinander beabstandet werden können, so daß die Leiterbahnen bezüglich der Substratoberfläche übereinander stapelbar sind und somit mehrere Leiterbahnen mit dem Substratoberflächenbedarf einer einzelnen Leiterbahn angeordnet werden können.

Das erste elektrische Verbindungselement, das zweite elektrische Verbindungselement und die erste Leiterbahn sind in der ersten Verdrahtungsebene angeordnet, und die zweite Leiterbahn ist zumindest teilweise in der zweiten Verdrahtungsebene angeordnet. Dies ermöglicht eine platzsparende Anordnung von Leiterbahnen, die an elektrische Verbindungselemente angeschlossen sind.

Eine weitere vorteilhafte Ausgestaltung der integrierten Schaltung sieht vor, daß eine Mehrzahl von elektrischen Verbindungselementen entlang der zweiten Richtung nebeneinander angeordnet ist, wobei die elektrischen Verbindungselemente jeweils im Verlauf der ersten Richtung eine erste Zuleitung und eine zweite Zuleitung aufweisen und die ersten Zuleitungen der Mehrzahl von elektrischen Verbindungselementen miteinander verbunden sind. Hierdurch ist ermöglicht, daß die elektrischen Verbindungselemente mit einer gemeinsamen und somit platzsparenden Zuleitung an ein elektrisches Potential angeschlossen sind, welches je nach programmiertem Zustand des elektrischen Verbindungselements an dem zweiten Anschluß des elektrischen Verbindungselementes anliegt beziehungsweise bei aufgetrenntem elektrischen Verbindungselement nicht anliegt.

Eine weitere vorteilhafte Ausgestaltung der integrierten Schaltung sieht vor, daß in der zweiten Richtung neben dem ersten elektrischen Verbindungselement und dem zweiten elektrischen Verbindungselement weitere Verbindungselemente angeordnet sind, die jeweils mindestens den ersten Abstand voneinander aufweisen.

Die in unterschiedlichen Ebenen verlaufenden Anschlußleiterbahnen für die Verbindungselemente sind über einen vorzugsweise vertikal ausgerichteten Kontakt miteinander verbunden. Der Kontakt ist durch eine die Verdrahtungsebenen voneinander isolierende Isolationsschicht geführt.

Weitere vorteilhafte Ausgestaltungen der Erfindung sind Gegenstand der jeweiligen Unteransprüche.

Nachfolgend wird die Erfindung anhand von Ausführungsbeispielen und Figuren näher erläutert.

In den Figuren zeigen:
- Figur 1: eine Anordnung von elektrischen Verbindungselementen und Leiterbahnen, welche die elektrischen Verbindungselemente kontaktieren;
- Figur 2: eine weitere Anordnung von elektrischen Verbindungselementen, die mit einer abweichenden Anordnung von Leiterbahnen kontaktiert werden;
- Figur 3: eine weitere Anordnung von elektrischen Verbindungselementen, die mit Leiterbahnen kontaktiert werden, die in einer Mehrzahl von Verdrahtungsebenen angeordnet sind;
- Figur 4: einen Schnitt durch ein Substrat mit einem elektrischen Verbindungselement und Leiterbahnen;
- Figur 5: einen weiteren Schnitt durch ein Substrat mit einem elektrischen Verbindungselement und Leiterbahnen, die in einer ersten Verdrahtungsebene und einer zweiten Verdrahtungsebene angeordnet sind.

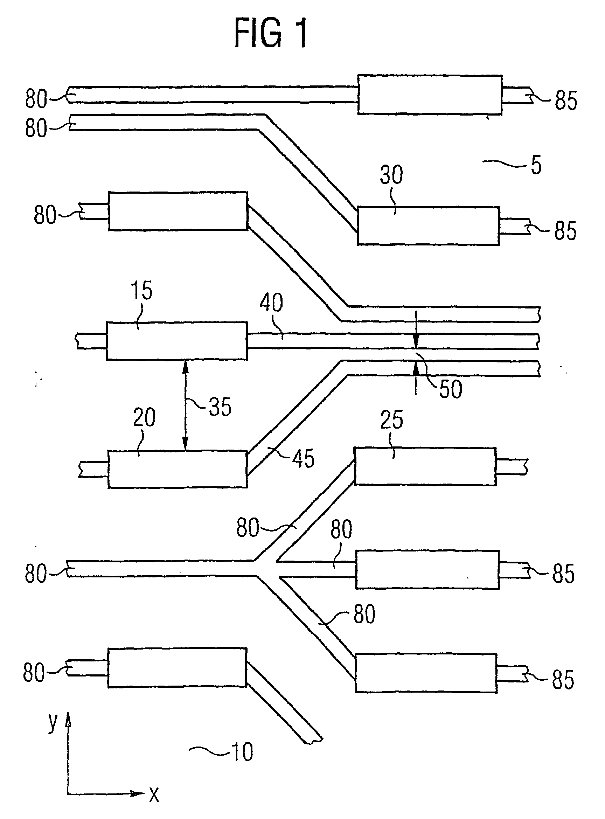

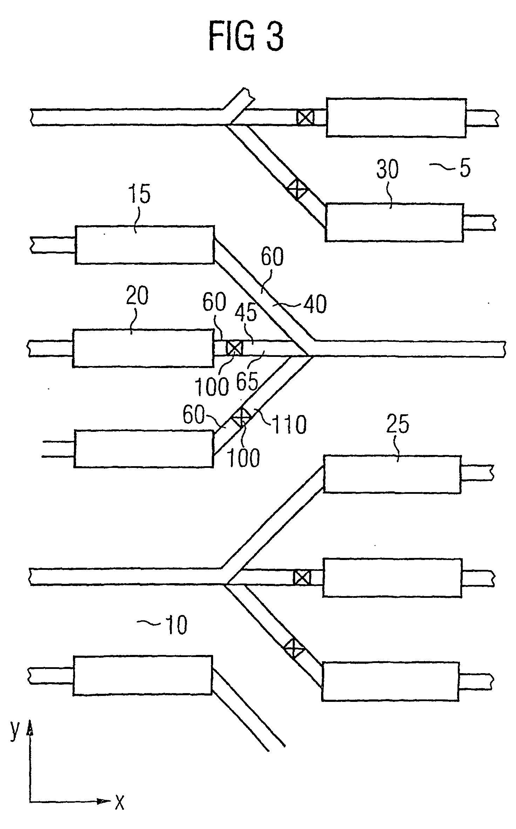

In Figur 1 ist ein Substrat 5 mit einer Substratoberfläche 10 dargestellt. Die Substratoberfläche 10 weist eine erste Ausdehnungsrichtung X und eine zweite Ausdehnungsrichtung Y auf, die senkrecht zu der ersten Richtung X angeordnet ist. Auf der Substratoberfläche 10 ist ein erstes elektrisches Verbindungselement 15 und ein zweites elektrisches Verbindungselement 20 entlang oder gesehen in der ersten Richtung Y nebeneinander angeordnet. Dies bedeutet, daß die Lage des Verbindungselements 15 aus der Lage des Verbindungselements 20 durch Parallelverschiebung längs der Richtung Y hervorgeht. Dies bedeutet, daß sämtliche horizontale dargestellte Kanten der Verbindungselemente 15, 20 in Figur 3 parallel zueinander verlaufen, während die vertikal dargestellten Kanten längs einer gleichen Geraden zueinander ausgerichtet verlaufen.

Es ist ein drittes elektrisches Verbindungselement 25 und ein viertes elektrisches Verbindungselement 30 im wesentlichen entlang der zweiten Richtung Y parallel zueinander verschoben auf der Substratoberfläche 10 angeordnet. Das dritte elektrische Verbindungselement 25 und das vierte elektrische Verbindungselement 30 sind entlang der ersten Richtung X von dem ersten elektrischen Verbindungselement 15 und dem zweiten elektrischen Verbindungselement 20 beabstandet. Die linksseitigen Enden der Verbindungselemente 25, 30 und die rechtsseitigen Enden der Verbindungselemente 15, 20 weisen einen Abstand voneinander auf. Dabei sind die linksseitigen Enden der Verbindungselemente 25, 30 rechts neben den rechtsseitigen Enden der Verbindungselemente 15, 20 angeordnet.

Das erste elektrische Verbindungselement 15 und das zweite elektrische Verbindungselement 20 weisen entlang der zweiten Richtung Y einen ersten Abstand 35 auf. Das erste elektrische Verbindungselement 15 ist mit einer ersten Leiterbahn 40 verbunden, die auf der Substratoberfläche 10 angeordnet ist. Das zweite elektrische Verbindungselement 20 ist mit einer zweiten Leiterbahn 45 verbunden, die auf der Substratoberfläche 10 angeordnet ist. Die erste Leiterbahn 40 und die zweite Leiterbahn 45 sind zwischen dem dritten elektrischen Verbindungselement 25 und dem vierten elektrischen Verbindungselement 30 angeordnet und weisen dort einen zweiten Abstand 50 voneinander auf. Der zweite Abstand 50 ist kleiner als der erste Abstand 35.

Das dritte elektrische Verbindungselement 25 und das vierte elektrische Verbindungselement 30 sind im wesentlichen entlang der zweiten Richtung Y zueinander verschoben angeordnet. Dies bedeutet, daß beispielsweise die Verbindungslinie zwischen dem Schwerpunkt des dritten elektrischen Verbindungselementes 25 und des vierten elektrischen Verbindungselements 30einen Winkel zu der zweiten Richtung Y aufweist, der zwischen 0° und 45° betragen kann.

Die auf der Substratoberfläche 10 angeordneten elektrischen Verbindungselemente weisen eine erste Zuleitung 80 und eine zweite Zuleitung 85 auf, die im wesentlichen entlang der ersten Richtung X verlaufen. Beispielsweise können die ersten Zuleitungen 80 miteinander verbunden sein, wie es für das dritte elektrische Verbindungselement 25 mit den zum ihm benachbarten Verbindungselementen gezeigt ist. Dies weist den Vorteil auf, daß fast die Hälfte der Zuleitungen zu der Fuse-Bank eingespart werden kann, falls sie durch eine gemeinsame Zuleitung ersetzt werden.

Die elektrischen Verbindungselemente beziehungsweise Sicherungen, die in Figur 1 dargestellt sind, sind matrixartig angeordnet. Dabei sind die Koordinaten der Matrix nicht vollständig mit Sicherungen besetzt, sondern einige Sicherungen sind ausgespart, so daß dort Leiterbahnen auf der Substratoberfläche 10 angeordnet werden können.

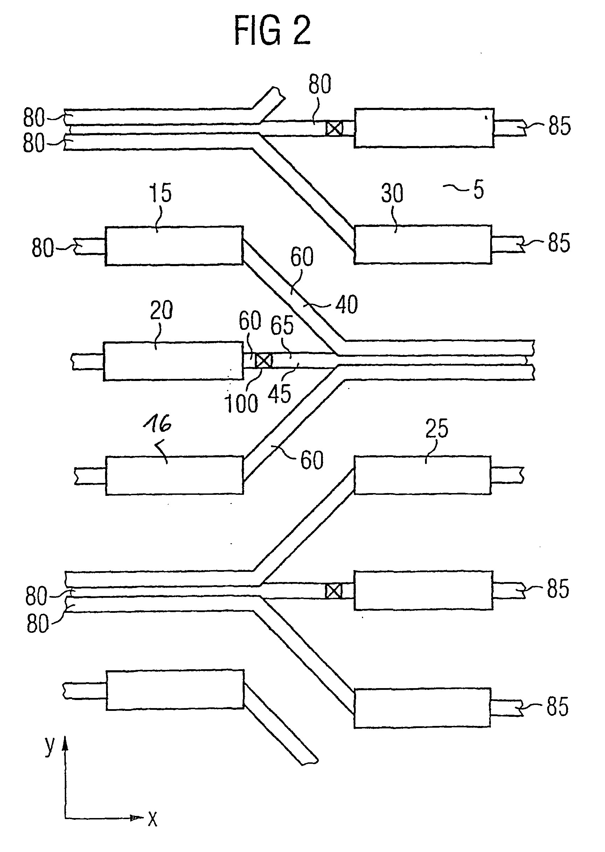

In Figur 2 ist eine Anordnung von elektrischen Verbindungselementen gemäß Figur 1 dargestellt, bei der allerdings die Leiterbahnen, die mit den elektrischen Verbindungselementen verbunden sind, anders verlaufen als in Figur 1. Auf der Substratoberfläche 10 ist eine erste Verdrahtungsebene 60 und eine zweite Verdrahtungsebene 65 angeordnet. Die erste Verdrahtungsebene 60 weist einen dritten Abstand 70 zu der Substratoberfläche 10 auf und die zweite Verdrahtungsebene 65 weist einen vierten Abstand 75 zu der Substratoberfläche 10 auf. Der dritte Abstand 70 ist dabei von dem vierten Abstand 75 verschieden. Beispielsweise sind das erste elektrische Verbindungselement 15, das zweite elektrische Verbindungselement 20 und die erste Leiterbahn 40 in der ersten Verdrahtungsebene 60 angeordnet und die zweite Leiterbahn 45 ist zumindest teilweise in zweiten Verdrahtungsebene 65 angeordnet. Als Verbindungselement innerhalb der zweiten Leiterbahn 45, zwischen der ersten Verdrahtungsebene 60 und der zweiten Verdrahtungsebene 65, ist ein Kontaktplug 100 angeordnet.

Weiterhin ist dargestellt, daß im Gegensatz zu Figur 1 die erste Leiterbahn 40 oberhalb der zweiten Leiterbahn 45 verläuft, wodurch eine Platzeinsparung von Substratoberfläche 10 ermöglicht ist. In senkrechter Aufsicht auf die Substratoberfläche wird die in der zweiten, unteren Verdrahtungsebene verlaufende Leiterbahn 45 teilweise überdeckt von den beiden in der ersten, oberen Verdrahtungsebene verlaufenden Anschlußleiterbahnen an die zum Verdrahtungselement 20 unmittelbar benachbart angeordneten Verbindungselemente 15, 16.

In Figur 3 ist ein weiteres Ausführungsbeispiel der Erfindung dargestellt. Hierbei werden die an die elektrischen Verbindungselemente angeschlossenen Leiterbahnen in einer ersten Verdrahtungsebene 60, einer zweiten Verdrahtungsebene 65 und einer dritten Verdrahtungsebene 110 angeordnet. Dadurch ist es möglich, daß drei Leiterbahnen zum Anschluß der elektrischen Verbindungselemente übereinander verlaufen und somit platzsparend angeordnet werden können. Innerhalb einer Leiterbahn sind die verschiedenen Verdrahtungsebenen mittels Kontaktplugs 100 miteinander verbunden.

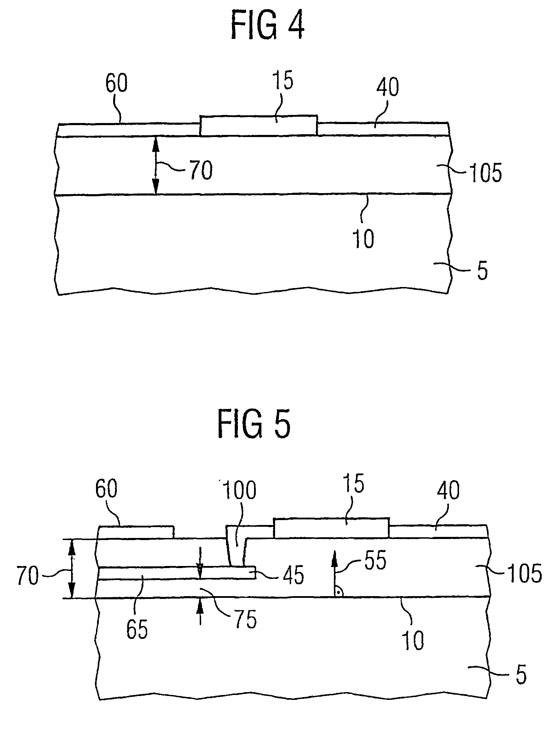

In Figur 4 ist ein Schnitt durch das Substrat 5 dargestellt. Das Substrat 5 weist eine Substratoberfläche 10 auf, auf der eine Isolationsschicht 105 angeordnet ist. Auf der Isolationsschicht 105 ist eine erste Verdrahtungsebene 60 angeordnet, in der beispielsweise das erste elektrische Verbindungselement 15 und die erste Leiterbahn 40 angeordnet sind. Die erste Verdrahtungsebene 60 weist einen dritten Abstand 70 von der Substratoberfläche 10 auf.

In Figur 5 ist ein weiterer Schnitt durch das Substrat 5 dargestellt. Das Substrat 5 weist die Substratoberfläche 10 auf, auf der die Isolationsschicht 105 angeordnet ist. Auf der Isolationsschicht 105 ist das erste elektrische Verbindungselement 15 mit der ersten Leiterbahn 40 dargestellt. Auf der Substratoberfläche 10 ist eine Substratoberflächen-Normale 55 dargestellt, die senkrecht auf der Substratoberfläche 10 steht. Das erste elektrische Verbindungselement 15 und die erste Leiterbahn 40 sind in der ersten Verdrahtungsebene 60 angeordnet, die einen dritten Abstand 70 zu der Substratoberfläche 10 aufweist. Weiterhin ist eine zweite Verdrahtungsebene 65 dargestellt, die einen vierten Abstand 75 von der Substratoberfläche 10 aufweist. Die Isolationsschicht 105 isoliert die Verdrahtungsebenen 60, 65 voneinander. Die zweite Verdrahtungsebene 65 ist mit einem Kontaktplug 100 mit der ersten Verdrahtungsebene 60 und dem ersten elektrischen Verbindungselement 15 verbunden. Der dritte Abstand 70 ist hierbei größer ausgebildet als der vierte Abstand 75. Der Kontakt 100 verläuft im wesentlichen entlang der Normalen 55, also senkrecht zur Substratoberfläche 10 gerichtet.

Es sind ebenfalls Anordnungen mit denkbar, bei denen mehr als zwei oder auch mehr als fünf elektrische Verbindungselemente in einer Gruppe angeordnet werden, wobei benachbarte elektrische Verbindungselemente einer Gruppe jeweils einen Abstand voneinander aufweisen, der dem ersten Abstand 35 entspricht. Zur Verdrahtung der einzelnen elektrischen Verbindungselemente sind sämtliche Verdrahtungsebenen eines Halbleiterbauelements verwendbar.

### Bezugszeichenliste

- 5: Substrat
- 10: Substratoberfläche
- X: erste Richtung
- Y: zweite Richtung
- 15: erstes elektrisches Verbindungselement
- 20: zweites elektrisches Verbindungselement
- 25: drittes elektrisches Verbindungselement
- 30: viertes elektrisches Verbindungselement
- 35: erster Abstand
- 40: erste Leiterbahn
- 45: zweite Leiterbahn
- 50: zweiter Abstand
- 55: Substratnormale
- 60: erste Verdrahtungsebene
- 65: zweite Verdrahtungsebene
- 70: dritter Abstand
- 75: vierter Abstand
- 80: erste Zuleitung
- 85: zweite Zuleitung
- 90: Leiterbahnen
- 95: elektrisches Verbindungselement
- 100: Kontaktplug
- 105: Isolationsschicht
- 110: dritte Verdrahtungsebene

## Patentansprüche

1. Integrierte Schaltung mit elektrischen Verbindungselementen, die jeweils einen ersten Leitfähigkeitszustand oder einen durch Energieeinprägung herbeiführbaren anderen zweiten Leitfähigkeitszustand aufweisen, umfassend:
- ein Substrat (5) mit einer Substratoberfläche (10), die eine erste Ausdehnungsrichtung (X) und eine senkrecht dazu verlaufende zweite Ausdehnungsrichtung (Y) aufweist;
- ein erstes elektrisches Verbindungselement (15) und ein zweites elektrisches Verbindungselement (20), die gesehen in der zweiten Richtung (Y) nebeneinander oberhalb der Substratoberfläche (10) in einer ersten Verdrahtungsebene (60) angeordnet sind;
- ein drittes elektrisches Verbindungselement (25) und ein viertes elektrisches Verbindungselement (30), die im wesentlichen gesehen in der zweiten Richtung (Y) nebeneinander auf der Substratoberfläche (10) angeordnet sind;
- wobei ein Ende des dritten elektrischen Verbindungselements (25) und ein Ende des vierten elektrischen Verbindungselements (30) entlang der ersten Richtung (X) von einem Ende des ersten elektrischen Verbindungselements (15) und einem Ende des zweiten elektrischen Verbindungselements (20) beabstandet sind und
- wobei das erste elektrische Verbindungselement (15) gesehen in der zweiten Richtung (Y) einen ersten Abstand (35) von dem zweiten elektrischen Verbindungselement (20) aufweist;
- eine erste Leiterbahn (40), die oberhalb der Substratoberfläche (10) angeordnet ist und mit dem ersten elektrischen Verbindungselement (15) verbunden ist;
- eine zweite Leiterbahn (45), die oberhalb der Substratoberfläche (10) angeordnet ist und mit dem zweiten elektrischen Verbindungselement (20) verbunden ist;
- wobei die erste Leiterbahn (40) und die zweite Leiterbahn (45) zwischen dem dritten elektrischen Verbindungselement (25) und dem vierten elektrischen Verbindungselement (30) angeordnet sind und dort einen zweiten Abstand (50) aufweisen, der kleiner ist als der erste Abstand (35);
- und die erste Leiterbahn (40) in der ersten Verdrahtungsebene (60) angeordnet ist und die zweite Leiterbahn (45) zumindest teilweise in einer zweiten Verdrahtungsebene (65) angeordnet ist, die näher zur Substratoberfläche (10) liegt als die erste Verdrahtungsebene (60).

2. Integrierte Schaltung nach Anspruch 1,
**dadurch gekennzeichnet, daß**
die erste Leiterbahn (40) und die zweite Leiterbahn (45) in Richtung einer Substratnormalen (55) gesehen, die senkrecht auf der Substratoberfläche (10) angeordnet ist, zumindest teilweise überlappend angeordnet sind.

3. Integrierte Schaltung nach Anspruch 1 oder 2,
**dadurch gekennzeichnet, daß**
die zweite Leiterbahn (45) einen ersten Abschnitt aufweist, der an das zweite Verbindungselement (20) angeschlossen ist und in der ersten Verdrahtungsebene (60) verläuft, und einen zweiten Abschnitt, der in der zweiten Verdrahtungsebene (65) verläuft, und daß der erste und der zweite Abschnitt der zweiten Leiterbahn (45) über einen von der ersten zur zweiten Verdrahtungsebene (60, 65) verlaufenden Kontakt (100) miteinander verbunden sind.

4. Integrierte Schaltung nach Anspruch 3,
**dadurch gekennzeichnet, daß**
die erste und die zweite Verdrahtungsebene (60, 65) durch eine Isolationsschicht (105) voneinander getrennt sind und daß der Kontakt (100) durch die Isolationsschicht (105) hindurch im wesentlichen in zur Substratoberfläche (10) vertikal verlaufende Richtung (55) geführt ist.

5. Integrierte Schaltung nach einem der Ansprüche 1 bis 4,
**dadurch gekennzeichnet, daß**
eine Mehrzahl von elektrischen Verbindungselementen gesehen in der zweiten Richtung (Y) nebeneinander angeordnet ist, wobei die elektrischen Verbindungselemente jeweils im Verlauf der ersten Richtung (X) eine erste Zuleitung (80) und eine zweite Zuleitung (85) aufweisen und die ersten Zuleitungen (80) der Mehrzahl von elektrischen Verbindungselementen miteinander verbunden sind.

6. Integrierte Schaltung nach einem der Ansprüche 1 bis 5,
**dadurch gekennzeichnet, daß**
gesehen in der zweiten Richtung (Y) neben dem ersten elektrischen Verbindungselement (15) und dem zweiten elektrischen Verbindungselement (20) weitere Verbindungselemente angeordnet sind, die jeweils mindestens den ersten Abstand (35) voneinander aufweisen.

## Claims

1. Integrated circuit having electrical connecting elements which each have a first conductivity state or a different, second conductivity state which can be brought about by impressing energy, comprising:
- a substrate (5) having a substrate surface (10), which has a first extension direction (X) and a second extension direction (Y), running perpendicularly thereto;
- a first electrical connecting element (15) and a second electrical connecting element (20), which, as seen in the second direction (Y), are arranged next to one another above the substrate surface (10) in a first wiring plane (60);
- a third electrical connecting element (25) and a fourth electrical connecting element (30), which, as essentially seen in the second direction (Y), are arranged next to one another on the substrate surface (10);
- one end of the third electrical connecting element (25) and one end of the fourth electrical connecting element (30) being spaced apart along the first direction (X) from one end of the first electrical connecting element (15) and one end of the second electrical connecting element (20), and
- the first electrical connecting element (15), as seen in the second direction (Y), being at a first distance (35) from the second electrical connecting element (20);
- a first interconnect (40), which is arranged above the substrate surface (10) and is connected to the first electrical connecting element (15);
- a second interconnect (45), which is arranged above the substrate surface (10) and is connected to the second electrical connecting element (20);
- the first interconnect (40) and the second interconnect (45) being arranged between the third electrical connecting element (25) and the fourth electrical connecting element (30) and there being at a second distance (50), which is smaller than the first distance (35);
- and the first interconnect (40) being arranged in the first wiring plane (60) and the second interconnect (45) being arranged at least partly in a second wiring plane (65), which is located nearer to the substrate surface (10) than the first wiring plane (60).

2. Integrated circuit according to Claim 1,
**characterized in that**
the first interconnect (40) and the second interconnect (45) are arranged in an at least partly overlapping manner as seen in the direction of a normal (55) to the substrate, the said normal being arranged perpendicular to the substrate surface (10).

3. Integrated circuit according to Claim 1 or 2,
**characterized in that**
the second interconnect (45) has a first section, which is connected to the second connecting element (20) and runs in the first wiring plane (60), and a second section, which runs in the second wiring plane (65), and **in that** the first and second sections of the second interconnect (45) are connected to one another via a contact (100) running from the first to the second wiring plane (60, 65).

4. Integrated circuit according to Claim 3,
**characterized in that**
the first and second wiring planes (60, 65) are isolated from one another by an insulation layer (105), and **in that** the contact (100) is led through the insulation layer (105) essentially in a direction (55) running vertically with respect to the substrate surface (10).

5. Integrated circuit according to one of Claims 1 to 4,
**characterized in that**
a plurality of electrical connecting elements are arranged next to one another as seen in the second direction (Y), the electrical connecting elements each having a first lead (80) and a second lead (85) in the course of the first direction (X) and the first leads (80) of the plurality of electrical connecting elements being connected to one another.

6. Integrated circuit according to one of Claims 1 to 5,
**characterized in that**
further connecting elements, which are in each case at least at the first distance (35) from one another, are arranged next to the first electrical connecting element (15) and the second electrical connecting element (20) as seen in the second direction (Y).

## Revendications

1. Circuit intégré ayant des éléments de connexion électriques qui ont respectivement un premier état de conductivité ou un autre deuxième état de conductivité pouvant être provoqué par une application d'énergie, comprenant :
- un substrat (5) ayant une surface (10) de substrat qui a une première direction (X) d'étendue et une deuxième direction (Y) d'étendue perpendiculaire à celle-ci ;
- un premier élément (15) de connexion électrique et un deuxième élément (20) de connexion électrique qui, considérés dans la deuxième direction (Y), sont disposés l'un à côté de l'autre au-dessus de la surface (10) du substrat dans un premier plan (60) de câblage ;
- un troisième élément (25) de connexion électrique et un quatrième élément (30) de connexion électrique qui, considérés sensiblement dans la deuxième direction (Y), sont disposés l'un à côté de l'autre sur la surface (10) du substrat ;
- une extrémité du troisième élément (25) de connexion électrique et une extrémité du quatrième élément (30) de connexion électrique étant, le long de la première direction (X), à distance d'une extrémité du premier élément (15) de connexion électrique et d'une extrémité du deuxième élément (20) de connexion électrique et
- le premier élément (15) de connexion électrique est, considéré dans la deuxième direction (Y), à une première distance (35) du deuxième élément (20) de connexion électrique ;
- une première piste (40) conductrice qui est disposée au-dessus de la surface (10) du substrat et qui est reliée au premier élément (15) de connexion électrique ;
- une deuxième piste (45) conductrice qui est disposée au-dessus de la surface (10) du substrat et qui est reliée au deuxième élément (20) de connexion électrique ;
- la première piste (40) conductrice et la deuxième piste (45) électrique étant disposées entre le troisième élément (25) de connexion électrique et le quatrième élément (30) de connexion électrique en y étant à une deuxième distance (50) qui est plus petite que la première distance (35) ;
- et la première piste (40) conductrice est disposée dans le premier plan (60) de câblage et la deuxième piste (45) conductrice est disposée au moins en partie dans un deuxième plan (65) de câblage qui est plus près de la surface (10) du substrat que ne l'est le premier plan (60) de câblage.

2. Circuit intégré suivant la revendication 1,
**caractérisé en ce que** la première piste (40) conductrice et la deuxième piste (45) conductrice sont disposées, considérées dans la direction d'une normale (55) au substrat qui est perpendiculaire sur la surface (10) du substrat, au moins en partie à chevauchement.

3. Circuit intégré suivant la revendication 1 ou 2,
**caractérisé en ce que** la deuxième piste (45) conductrice a un premier tronçon qui est raccordé au deuxième élément (20) de connexion et qui s'étend dans le premier plan (60) de câblage, et un deuxième tronçon qui s'étend dans le deuxième plan (65) de câblage, et **en ce que** le premier et le deuxième tronçons de la deuxième piste (45) conductrice sont reliés entre eux par un contact (100) s'étendant du premier plan (60) de câblage au deuxième plan (65) de câblage.

4. Circuit intégré suivant la revendication 3,
**caractérisé en ce que** le premier plan (60) de câblage et le deuxième plan (65) de câblage sont séparés l'un de l'autre par une couche (105) isolante, et **en ce que** le contact (100) traverse la couche (105) isolante sensiblement dans une direction (55) s'étendant verticalement par rapport à la surface (10) du substrat.

5. Circuit intégré suivant l'une des revendications 1 à 4,
**caractérisé en ce qu'**une pluralité d'éléments de connexion électriques sont, considérés dans la deuxième direction (Y), disposés les uns à côté des autres, les éléments de connexion électriques ayant respectivement, s'étendant dans la première direction (X), une première ligne (80) d'entrée et une deuxième ligne (85) d'entrée, et les premières lignes (80) d'entrée de la pluralité d'éléments de connexion électriques sont reliées entre eux.

6. Circuit intégré suivant l'une des revendications 1 à 5,
**caractérisé en ce que** d'autres éléments de connexion, qui sont entre eux respectivement au moins à la première distance (35), sont disposés, considérés dans la deuxième direction (Y), à côté du premier élément (15) de connexion électrique et du deuxième élément (20) de connexion électrique.
